# EUROPEAN PATENT SPECIFICATION

(11) **EP 1 419 597 B1**
(45) Date of publication and mention of the grant of the patent: **19.04.2006**
(21) Application number: 01969644.2
(22) Date of filing: 24.08.2001
(51) Int. Cl.: H04B 17/00, H04L 27/36, H03F 1/32

(54) **Method and device for enhancing quality of signal transmission**
Verfahren und Vorrichtung zur Verbesserung der Signalübertragungsqualität
Dispositif et procédé permettant d'améliorer la qualité de transmission de signaux

(43) Date of publication of application: 19.05.2004
(73) Proprietor: SIEMENS AKTIENGESELLSCHAFT, 80333 München (DE)
(72) Inventor: STICHELBOUT, Thomas, DK-9000 Allborg (DK)
(86) International application number: PCT/EP2001/009805
(87) International publication number: WO 2003/019825

(56) References cited:
- EP-A2- 0 690 593
- WO-A1-00/59171
- GB-A- 2 314 485

## Description

The present invention relates to a method and to a device for enhancing the quality of data signals transmitted between a mobile user equipment and a base station.
In the field of radio communication, such as satellite communication or mobile communication, there is an increasing need of capacity, channels and bandwidth for data transmission caused by the still growing number of users and data services. The present invention addresses to these systems denoting them as RF systems altogether.

However, more complex methods of coding, modulation and strict standards are used to supply sufficient numbers of channels of a determined quality. So, the Global Standard for Mobile communication GSM became extended to Enhanced Data rate for GSM Evolution, GSM-EDGE, using a quadrature modulation technique to meet the aforesaid needs.

Usually a direct conversion receiver is used in a radio frequency receiving unit. This is a receiver with a single mixer in the receive path, where the RF modulated frequency carrier is converted to a base-band directly. That means that the RF modulated frequency is transformed in a single step with the help of a frequency mixer and an appropriate local oscillator. Advantageously the homodyne type of receiver may be built in the form of very high integrated circuits. So, this type of receiver is preferred in any field focusing on miniaturisation, e.g. mobile telecommunication.

However, in complex modulation scheme such as e.g. GSM-EDGE, the quality of the modulation transmitted at high frequency is highly sensitive to the linearity of the transmission chain and impairments such as e.g. amplitude, quadrature skew and phase noise, which are added during up and down frequency conversion. Each impairment added during the transmission of the signal degrades the received signal, including the impairment in the receiver chain. In particular, an in-phase component I and in-quadrature phase component Q of a quadrature modulated signal generated from the base band are degraded both by internal impairment due to the base band chip and the modulator, i.e. the first mixer stage, where impairments occur in amplitude, phase and DC offset.

At the present time, if taken into account the amplitude and the phase imbalance of an in-phase component I and in-quadrature phase component Q of a quadrature modulated signal, these signals usually are tuned manually to optimise the modulator in the transmitter side of the transceiver. Such a method and a system for calibrating a quadrature phase modulator are known from US5847619. According to the disclosure of this document a spectrum analyser is placed at the transmitter TX output to calibrate the transmitter. This method is well suited for a single time calibration. In a mass production process this method is much too time consuming as manual operation is included. However, the process calibration requires skilled operators. Further more this method does not insure that the tuning will remain valid if there is a drift in impairments e.g. due to ageing of the device. Furthermore this calibration only optimises the transmitter side of the transceiver. Any impairment in the mixer placed after a low noise amplifier within the receiver is usually not compensated by hardware tuning. Further, a direct comparison of I and Q signal components is not suitable as the modulation scheme does not present a constant envelope in system such as GSM-EDGE. In this particular case each amplitude shows a range of dynamic of about 17dB.

US5930286 discloses a gain imbalance compensation for a quadrature receiver in a cordless direct sequence spread spectrum telephone. The method disclosed uses a base station to monitor the quality of I/Q amplitude impairment, with a communication between the mobile user equipment and the base station. However, an active communication link is required for means of calibration.

WO0051971 and EP0690593 describe systems to enhance the quality of the transmitted data signal where the transmit signal is fed back to the receiver via a RF loop.

Usually other alternative approaches imply the use of additional hardware and/or external measurement.

The object of the present invention is to provide a method, a transmitting and receiving unit and a RF-system having an improved efficiency of data transmission and enhanced quality of the signals. It is a further object of the present invention to reduce the number of external measurement facilities avoiding manual operation of skilled operators. A even further object of the present invention is to achieve the aforesaid objects at a minimised amount of energy consumption at least at the side of the mobile equipment.

These objects are achieved by a method and a device having the features of claims 1 and 4 respectively. The depending claims contain the features of preferred embodiments of the invention respectively.

Therefore, according to the present invention, the base band signals I and Q are evaluated after the modulator within the transmitter and receiver unit while the output of the transmitter part is fed back into the receiver part analysing impairments for quality enhancement. Thus it is possible to tune both amplitude and quadrature phase errors to minimise the Error Vector Magnitude EMV. The Error Vector Magnitude EMV is estimated by the base band receiver. The values of amplitude and quadrature phase are adjusted to obtain the lowest value of the Error Vector Magnitude EVM. Even if the receiver presents impairments, it is possible to find an optimal settings of a phase and a digital amplitude of I and Q components in transmitter to obtain an minimal value of EVM rms.

However, as any aforesaid kind of impairment is known from both transmitter and receiver these impairments may be used to extinguish each other at least partially. In the best case an impairment between I and Q and the quadrature phase impairment between the mixer and the base band can partly cancel each other improving the Error Vector Magnitude EVM performance. This leaves an increased margin for non-linearities in blocks such as e.g. the power amplifier other than the modulator. In particular The mixer used to down-convert the signal does not need to be impairment free, i.e. phase noise in local oscillator LO and amplitude and quadrature phase impairment in receiver RX mixer, as the resulting contribution to the total measured Error Vector Magnitude EVM will remain constant during the tuning process. Further this approach minimises the efforts to be taken for optimisation.

According to the present invention the problem of optimisation is shifted from outside a unit into the base band unit which is working in a region of lower frequencies using existing means to a wide range. Thus, it has to be noted that according to the present invention it is not a necessity to reuse the high radio frequency RF mixer from a direct conversion receiver DCR in the receive path as the intermediate frequency IF in the transmission path is usually lower than 500 MHz. The frequency mixer in the receive path should also be kept in the linear zone of operation.

However, no further components are required from outside a unit according to the present invention. Further a closed control loop is working automatically. That means that the loop is able to work and to optimise parameters characteristic for the quality of a communication by adjusting parameters for minimising impairments without manual operation of skilled operators. This optimisation is carried out without any communication link to another unit, too. No extra communication effort is necessary. Thus a method according to claim 1 saves electric energy which still is a rare resource at the side of e.g. a mobile user equipment. Reducing the bit error rate by enhancing the quality of data transmission improves the efficiency of the whole system, too.

In a development of the invention the output of the modulator is not fed to the frequency up-conversion stage during the tuning process. In other words the transmitting path is idle. In an preferred embodiment of the invention this method is carried out within any idle time, e.g. a time period without an active communication link.

Advantageously the phase of optimisation according to the method disclosed is entered via a control signal generated within the base band unit itself. This control signal changes the state of two switches at once. The switches open a signal path from an antenna to the receiver and a signal path from the transmitter to the up conversion stage. In their second state the switches connect a feed back branch between the output of the transmitter and the input of the receiver. Thus, a base band signal of the unit is analysed concerning any kind of impairment. However said signal starts a process of optimisation.

In an embodiment of the invention the Error Vector Magnitude EVM is calculated with a dummy. However, it is preferred to use a known data sequence respecting the complex modulation format considered. According to a further development of the invention this data sequence represents optimised settings e.g. received from a proceeding cycle of optimisation now serving as starting conditions for optimisation in the next update of the tuning. In the last case the base band unit is supplied with a memory for storing these settings. However, the EVM measurement is available in the receiver when considering for example EDGE modulation both up and down-link.

Thus, the optimisation of the tuning process is done on a regular basis to compensate for the hardware static error and potential drift due to ageing.

In an embodiment of the invention the method disclosed is used to improve the interconnection between a given base band circuit, such as S-gold by Infineon if there was separated I/Q for TX and RX, and a known RF chipset, e.g. the Othello One chipset by Analog Devices Inc..

However the method disclosed is described with respect to GSM EDGE only it may also apply in any kind of homodyne apparatus. So, this invention applies in any homodyne, with a mixer for up and down conversion as long as the mixers do not operate near their 1-dB compression point. Further the method disclosed also applies when both the I and Q signals are modulated with a digital mixer where the interface to the RF chipset is placed after the mixer.

An embodiment of the invention will now be described with reference to the appended drawings, where:
- Fig. 1: shows a vector diagram to demonstrate the different kinds of impairments addressed by the present invention and
- Fig. 2: is a schematic diagram of a transmitting and receiving unit according to the present invention.

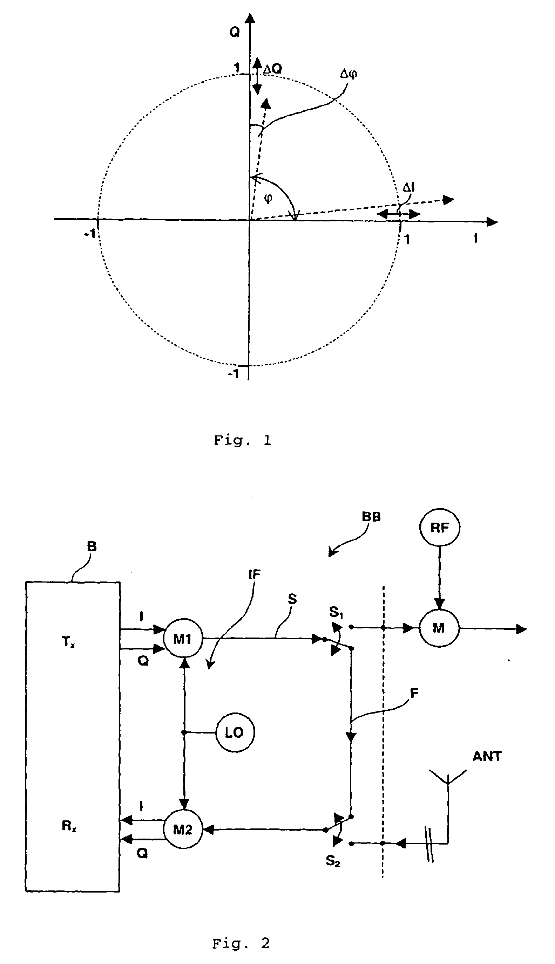

The drawing of Figure 1 represents a complex plane. In here base band signals I and Q are components of a quadrature amplitude modulated signal both having the absolute length of 1. Further, an quadrature phase angle ϕ between the in-phase and in-quadrature phase components I, Q of a quadrature modulated signal measures 90°. Thus, the states achievable lay on the dotted line of a circle or within a circle called the unity circle in the complex plane.

However, independent from the number of QAM-states impairments or mismatches of the amplitudes denoted ΔI and ΔQ represent errors of the in-phase and in-quadrature phase components of a quadrature modulated signal. Further Δϕ represents an errors or impairment of the quadrature phase angle ϕ. Each of these impairments added during up and down frequency conversion degrades the signal thus reducing the quality of a speech signal and/or causing an increasing bit error rate BER within a data signal transmitted digitally.

The schematic diagram of Fig. 2 shows a base band section BB of a transmitting and receiving unit U according to the present invention. The base band section BB comprises a block B representing a base band unit comprising a transmitter Tx and a receiver Rx both comprising ports for a in-phase component I and in-quadrature phase component Q of a quadrature modulated signal S respectively. The transmitter Tx outputs the base band signals I and Q feeding them into a modulator, where the modulator is represented by the multiplier M1. A local oscillator LO feeds the mixer M1, too. The quadrature amplitude modulated signal S having the components I and Q is the result of this step. Under normal conditions the signal S contains pieces of information or any kind of data to be transmitted to a remote partner via an antenna ANT. Thus, the signal S needs to be shifted in the frequency plane by at least one mixer M from a intermediate frequency IF to become a radio frequency RF signal. As these steps beyond the base band section BB are not of interest for the understanding of the present invention they are mentioned in short only without describing details.

However, the impairments mentioned above degrade the quality of a signal S to be transmitted. On the other hand a processing of a received signal being fed to a base band receiver Rx suffers likely from same deficiencies. To give an example, both paths are fed from the same local oscillator LO, whose phase noise degrades signals on the path to up-conversion and on the path vice versa as well. However, the influence of the mixers M1, M2 are likely to be almost the same.

According to the present invention the base band signals I and Q are evaluated within a closed loop. The evaluation takes place after the modulator while the output of the modulator is not fed to the frequency up-conversion stage during the tuning process. For this purpose the signal paths to up- and down-conversion are provided with switches S₁ and S₂ to connect a feed back branch F between the output of the transmitter Tx and the input of the receiver Rx. Thus, the block B receives known data including impairments. However, the impairments are extracted from the data. The impairments are analysed and used to achieve settings for optimising the quality of the signal minimising in effects of impairments detected. The techniques used are well known to a person skilled in the art. So there is no need for giving further detailed descriptions on these methods and means carrying them out.

This method does not need any communication link to any outstanding unit. Further tuning may be done at any idle time automatically. Even further it has to be stated that there are very few changes within known IF-circuits of transmitting and receiving units. Thus, an important field of use for the present invention is any kind of mobile communication, where the use in a mobile station in the form of a mobile GSM EDGE telephone is preferred.

Within the text and the drawings the following abbreviations are used:
- GSM: global system for Mobile communication
- EDGE: enhanced Data rates for GSM Evolution
- RF: radio frequency
- IF: intermediate frequency
- I/Q: in-phase and in-quadrature signals, phase components of a quadrature modulated signal
(whose envelope is given as I + j*Q)
- ϕ: quadrature phase
- ΔI, ΔQ, Δϕ: errors of I, Q and ϕ respectively
- ANT: antenna
- LO: local oscillator
- BB: base band section
- B: block
- Tx: transmitter
- Rx: receiver
- S: quadrature amplitude modulated signal
- M1: frequency mixer
- M2: frequency mixer
- M: frequency mixer
- F: feedback branch
- S1: switch
- S2: switch
- EVM: Error Vector Magnitude, see GSM 05.05, V8.5.0, release 99, Etsi spec EN 300 910 for the definition of EVM rms
- rms: root means square
- DCR: direct conversion receiver

## Claims

1. A method for enhancing quality of data signals transmitted between a mobile user equipment and a base station using a quadrature amplitude modulation, comprising the steps of:
- modulating an in-phase component (I) and an in-quadrature phase component (Q) of a signal from a transmitter (Tx), to a modulated signal (S);
- feeding the modulated signal (S) back to a receiver part (Rx) as a feedback signal;
- demodulating the feedback signal to an in-phase component and to an in-quadrature component of the feedback signal;
- evaluating impairments in the in-phase and in-quadrature components of the feedback signal; and
- in response to the evaluating step, obtaining settings for enhancing the quality of signal to be transmitted, by minimising the effect of impairements detected;
wherein the improvement comprises: the step of feeding the modulated signal (S) back to a receiver part (Rx) is performed before the modulated signal (S) is mixed to a radio frequency signal.

2. A method of claim 1, wherein: feeding the modulated signal (S) back to a receiver part (Rx) inhibits the mixing of the modulated signal (S) to a radio frequency signal.

3. A method of claim 1 or 2, wherein: a data sequence from a preceding evaluation step is used in the evaluating step as a starting value for computing an Error Vector Magnitude.

4. A device for enhancing quality of data signals transmitted between a mobile user equipment and a base station using a quadrature amplitude modulation, comprising:
- means (M1) for modulating an in-phase component (I) and an in-quadrature phase component (Q) of a signal from a transmitter (Tx), to a modulated signal (S);
- means (S1, S2) for feeding the modulated signal (S) back to a receiver part (Rx) as a feedback signal;
- means for demodulating (M2) the feedback signal to an in-phase component and to an in-quadrature component of the feedback signal;
- means (B) for evaluating impairments in the in-phase and in-quadrature components of the feedback signal; and
- means (B) responsive to the means (B) for evaluating impairments, adapted to obtain settings for enhancing the quality of signal to be transmitted by minimising the effect of impairments detected;
wherein the improvement comprises: the means (S1, S2) for feeding the modulated signal (S) back to a receiver part (Rx) are adapted to feed the modulated signal (S) before the signal (S) is fed to means (M) for mixing it to a radio frequency signal.

5. A device of claim 4, wherein: the means (S1, S2) for feeding the modulated signal (S) back to a receiver part (Rx) are further adapted to inhibit the feeding of the signal (S) to means (M) for mixing it to a radio frequency signal.

6. A device of claim 4 or 5, wherein: means (B) for evaluating impairments are adapted to use a data sequence obtained in a preceding cycle in the means (B) for evaluating impairments as a starting value for computing an Error Vector Magnitude.

## Patentansprüche

1. Verfahren zur Verbesserung der Qualität von Datensignalen, die mithilfe eines Quadratur-Amplituden-Modulationsverfahrens zwischen einem Mobilfunkteilnehmergerät und einer Basisstation übertragen werden, welches die folgenden Schritte umfasst:
- Modulieren einer "in Phase"-Komponente (I) und einer "in Quadratur"-Komponente (Q) eines Signals von einem Sender (Tx) zu einem modulierten Signal (S);
- Zurückleiten des modulierten Signals (S) an einen Empfängerteil (Rx) als Rückkopplungssignal;
- Demodulieren des Rückkopplungssignals zu einer "in Phase"-Komponente und zu einer "in Quadratur"-Komponente des Rückkopplungssignals;
- Auswerten der Beeinträchtigungen in der "in Phase"- und der "in Quadratur"-Komponente des Rückkopplungssignals; und
- als Reaktion auf den Auswertungsschritt Erzielen von Einstellungen zur Verbesserung der Qualität des zu übertragenden Signals, indem die Auswirkungen der erkannten Beeinträchtigungen auf ein Minimum reduziert werden;
wobei die Verbesserung Folgendes umfasst: Der Schritt des Zurückleitens des modulierten Signals (S) an einen Empfängerteil (Rx) wird ausgeführt, bevor das modulierte Signal (S) einem Hochfrequenz-Signal beigemischt wird.

2. Verfahren gemäß Anspruch 1, wobei: das Zurückleiten des modulierten Signals (S) an einen Empfängerteil (Rx) verhindert, dass das modulierte Signal (S) einem Hochfrequenz-Signal beigemischt wird.

3. Verfahren gemäß Anspruch 1 oder 2, wobei: eine Datensequenz aus einem vorangegangenen Auswertungsschritt im Auswertungsschritt als Ausgangswert für die Berechnung eines Fehlervektors EVM verwendet wird.

4. Vorrichtung zur Verbesserung der Qualität von Datensignalen, die mithilfe eines Quadratur-Amplituden-Modulationsverfahrens zwischen einem Mobilfunkteilnehmergerät und einer Basisstation übertragen werden, welche Folgendes umfasst:
- ein Mittel (M1) zum Modulieren einer "in Phase"-Komponente (I) und einer "in Quadratur"-Komponente (Q) eines Signals von einem Sender (Tx) zu einem modulierten Signal (S);
- Mittel(S1, S2) zum Zurückleiten des modulierten Signals (S) an einen Empfängerteil (Rx) als Rückkopplungssignal;
- ein Mittel zum Demodulieren (M2) des Rückkopplungssignals zu einer "in Phase"-Komponente und zu einer "in Quadratur"-Komponente des Rückkopplungssignals;
- ein Mittel (B) zur Auswertung der Beeinträchtigungen in der "in Phase"- und der "in Quadratur"-Komponente des Rückkopplungssignals; und
- ein Mittel (B), das auf das Mittel (B) zur Auswertung der Beeinträchtigungen reagiert, welches geeignet ist, Einstellungen zur Verbesserung der Qualität des zu übertragenden Signals zu erzielen, indem die Auswirkungen der erkannten Beeinträchtigungen auf ein Minimum reduziert werden;
wobei die Verbesserung Folgendes umfasst: Die Mittel (S1, S2) zum Zurückleiten des modulierten Signals (S) an einen Empfängerteil (Rx) sind dafür ausgelegt, das modulierte Signal (S) zuzuführen, bevor das Signal (S) dem Mittel (M) zugeführt wird, um einem Hochfrequenz-Signal beigemischt zu werden.

5. Vorrichtung gemäß Anspruch 4, wobei: Die Mittel (S1, S2) zum Zurückleiten des modulierten Signals (S) an einen Empfängerteil (Rx) ferner dafür ausgelegt sind, das Zuführen des modulierten Signals (S) zu dem Mittel (M) zwecks Beimischung zu einem Hochfrequenz-Signal zu verhindern.

6. Vorrichtung gemäß Anspruch 4 oder 5, wobei: Die Mittel (B) zum Auswerten der Beeinträchtigungen dafür ausgelegt sind, eine Datensequenz aus einem vorangegangenen Zyklus in dem Mittel (B) für die Beurteilung von Beeinträchtigungen als Ausgangswert für die Berechnung eines Fehlervektors EVM zu verwenden.

## Revendications

1. Procédé pour améliorer la qualité de signaux de données transmis entre un équipement d'utilisateur mobile et un poste de base qui utilisent une modulation d'amplitude en quadrature, le procédé comprenant les étapes :
- moduler en un signal modulé (S) la composante (I) en phase et la composante (Q) en quadrature de phase d'un signal provenant d'un émetteur (Tx),
- renvoyer à un récepteur (Rx) le signal modulé (S) comme signal de rétroaction,
- démoduler le signal de rétroaction en la composante en phase et en la composante en quadrature du signal de rétroaction,
- évaluer des dégradations de la composante en phase et de la composante en quadrature du signal de rétroaction et
- en réponse à l'étape d'évaluation, obtenir des réglages destinés à améliorer la qualité du signal à transmettre en minimisant l'effet des dégradations détectées,
l'amélioration comprenant que l'étape de renvoyer à un récepteur (Rx) le signal modulé (S) est réalisée avant de mélanger le signal modulé (S) avec un signal à fréquence radio.

2. Procédé selon la revendication 1, dans lequel le renvoi du signal modulé (S) à un récepteur (Rx) entrave le mélange du signal modulé (S) avec un signal à fréquence radio.

3. Procédé selon les revendications 1 ou 2, dans lequel une séquence de données d'une étape d'évaluation précédente est utilisée dans l'étape d'évaluation comme valeur de départ pour calculer la grandeur d'un vecteur d'erreur.

4. Dispositif pour améliorer la qualité de signaux de données transmis entre un équipement d'utilisateur mobile et un poste de base qui utilisent une modulation d'amplitude en quadrature, le dispositif comprenant :
- un moyen (M1) pour moduler en un signal modulé (S) la composante (I) en phase et la composante (Q) en quadrature de phase d'un signal provenant d'un émetteur (Tx),
- des moyens (S1, S2) pour renvoyer à un récepteur (Rx) le signal modulé (S) comme signal de rétroaction,
- un moyen (M2) pour démoduler le signal de rétroaction en la composante en phase et en la composante en quadrature du signal de rétroaction,
- des moyens (B) pour évaluer des dégradations de la composante en phase et de la composante en quadrature du signal de rétroaction et
- des moyens (B) qui répondent aux moyens (B) pour évaluer des dégradations et qui sont adaptés pour obtenir des réglages destinés à améliorer la qualité du signal à transmettre en minimisant l'effet des dégradations détectées,
l'amélioration comprenant que les moyens (S1, S2) pour renvoyer le signal modulé (S) au récepteur (Rx) sont adaptés pour délivrer le signal modulé (S) avant que le signal (S) soit délivré à un moyen (M) pour le mélanger avec un signal à fréquence radio.

5. Dispositif selon la revendication 4, dans lequel les moyens (S1, S2) pour renvoyer le signal modulé (S) à un récepteur (Rx) sont en outre adaptés pour entraver la transmission du signal (S) au moyen (M) pour le mélanger avec un signal à fréquence radio.

6. Dispositif selon les revendications 4 ou 5, dans lequel les moyens (B) pour évaluer des dégradations sont adaptés pour utiliser comme valeur de départ pour calculer la grandeur d'un vecteur d'erreur une séquence de données obtenue au cours d'un cycle précédent dans les moyens (B) pour évaluer des dégradations.
